# EUROPEAN PATENT SPECIFICATION

(11) **EP 1 154 561 B1**
(45) Date of publication and mention of the grant of the patent: **15.12.2004**
(21) Application number: 01108601.4
(22) Date of filing: 05.04.2001
(51) Int. Cl.: H03B 5/18, H03D 7/00

(54) **Microwave oscillator and low-noise converter using the same**
Mikrowellenoszillator und rauscharmer Umwandler mit einem solchen Oszillator
Oscillateur à micro-ondes et convertisseur à faible bruit utilisant ledit oscillateur

(30) Priority: 10.04.2000 JP 2000107545
(43) Date of publication of application: 14.11.2001
(73) Proprietor: MATSUSHITA ELECTRIC INDUSTRIAL CO., LTD., Kadoma-shi, Osaka 571-8501 (JP)
(72) Inventor: Kashima, Yukiro, Takatsuki-shi, Osaka, 569-1046 (JP)
(74) Representative: Kügele, Bernhard

(56) References cited:
- FR-A- 2 513 456
- US-A- 4 713 632
- US-A- 5 940 750
- LOHNINGER G: "FUNDAMENTALS OF OSCILLATORS FOR THE MICROWAVE RANGE (PART 2)" IEEE SIGNAL PROCESSING LETTERS, IEEE SIGNAL PROCESSING SOCIETY, US, vol. 6, no. 7, July 1999 (1999-07), pages 32-34, XP000833692 ISSN: 1070-9908
- MIZAN M: "An X-band, 2.5 watt continuous wave dielectric resonator oscillator for future military systems" PROCEEDINGS OF THE FREQUENCY CONTROL SYMPOSIUM. HERSHEY, MAY 27 - 29, 1992, NEW YORK, IEEE, US, 27 May 1992 (1992-05-27), pages 409-414, XP010056704 ISBN: 0-7803-0476-4

## Description

### FIELD OF THE INVENTION

The present invention relates to a microwave oscillator stabilized in frequency by using a dielectric resonator, and a low-noise converter incorporated in a radio wave receiving antenna of broadcast or communication satellite.

### BACKGROUND OF THE INVENTION

Recently, along with progress in digital signal compression technology of moving picture or integrated circuit for digital signal processing, in the television broadcast by broadcast satellite or communication satellite, the analog transmission system is being replaced by the digital transmission system which is capable of presenting broadcast and communication services of higher picture quality in multiple channels, and its spread in the general household is highly expected. In this background, there is an increasing demand not only for smaller size and lower cost of low-noise converter used in the receiving antenna of broadcast or communication satellite radio waves, but also for further improvement of phase noise characteristics of the microwave oscillator incorporated in the low-noise converter which has a serious effect on the quality of bit error rate (BER) of decoded signals in the receiver when the quadrature phase shift keying or octantal phase shift keying is employed as the digital transmission system.

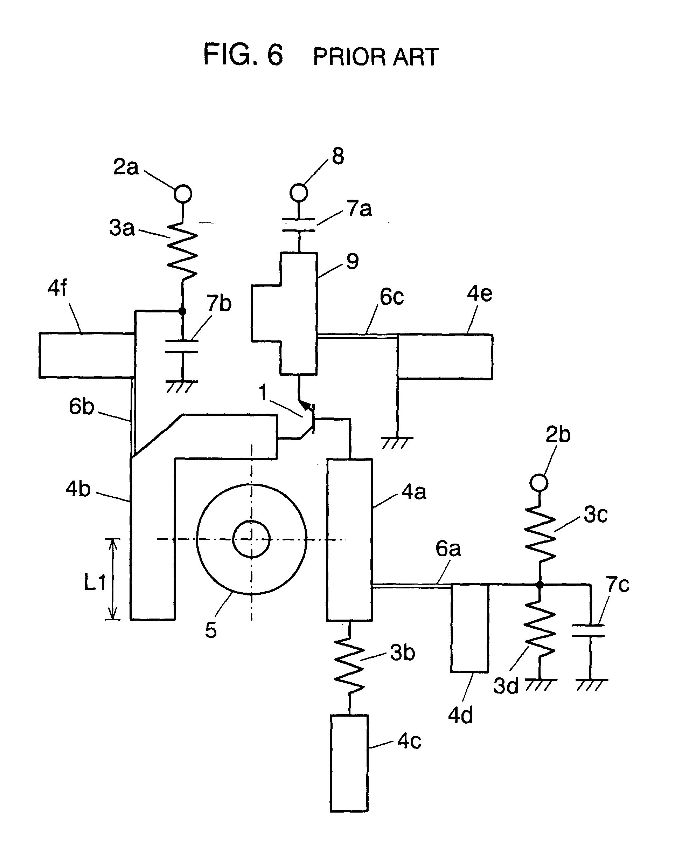

Fig. 6 is a circuit diagram of a microwave oscillator hitherto used as the local oscillator of a low-noise converter. At base terminal of a bipolar transistor 1 for microwave oscillation (hereinafter the bipolar transistor is called merely as a transistor be distinguished from the field effect transistor or FET), a microstrip line (MSL) 4a is connected. In this line 4a, a choke circuit composed of high impedance line (HIL) 6a and MSL 4d, and a dc voltage divider composed of dc resistances 3c and 3d are connected serially as shown in the diagram, and one end of the resistance 3c is connected to a bias supply terminal 2b of the transistor, and a bias voltage is applied to the base terminal therefrom. A capacitor 7c for grounding the microwave component leaking out from the HIL 6a is connected parallel to the resistance 3d, and one end is grounded. At a terminal end of the MSL 4a, a series circuit of a high frequency resistance 3b and MSL 4c of which one end is released, having a length of λg/4 is connected as shown in the diagram, and a resistive terminal end is formed in the MSL 4a. Herein, λg is the guide wavelength of the MSL 4c corresponding to the oscillation frequency. (Hereinafter, λg is meant as the guide wavelength determined by the corresponding MSL. The value of λg varies with the line width of MSL, thickness of circuit board, and dielectric constant.)

The MSL 4b is connected to the collector of transistor 1, and in this line 4b, a choke circuit of HIL 6b and MSL 4f and a dc resistance 3a are connected as shown in the diagram, and one end of the resistance 3a is connected to a bias supply terminal 2a of the transistor, and a bias voltage is applied to the collector terminal therefrom. A capacitor 7b for grounding the microwave component leaking out from the HIL 6b is connected serially to the resistance 3a, and one end is grounded.

A hollow circular dielectric resonator (DR) 5 couples the MSL 4a and 4b electromagnetically, and is arranged so that the distance from its release end to the closest position to the center of the DR 5 may be λg/4 on the MSL 4b.

In this configuration, by feeding back from the collector to the base of the transistor 1 through the DR 5, the oscillation frequency and oscillation power are stabilized at the frequency determined by the resonance frequency of the DR 5, and the oscillation power is delivered from an output terminal 8 through an impedance matching circuit 9 and a dc blocking capacitor 7a connected to the emitter of the transistor 1.

Meanwhile, the HIL 6c and MSL 4e connected to the matching circuit 9 form a choke circuit, and are used for preventing leak of microwave oscillation power and grounding the emitter of the transistor 1 in direct current.

This conventional configuration, however, requires choke circuits composed of HIL 6a, 6b, 6c and MSL 4d, 4f, 4e which are connected for applying a dc bias to the MSL 4a, 4b connected to the corresponding terminals of the transistor 1 and connected to the impedance matching circuit 9, and these choke circuits make it difficult to reduce the size of the microwave oscillator or induce deterioration of phase noise characteristics, generation of spurious oscillation, or other unstable oscillation. A similar oscillator circuit is known from Lohinger, G: "Fundamentals of oscillators for the microwave range (Part 2)", IEEE Signal Processing Letters, IEEE Signal Processing Society, vol 6, no 7, July 1999, pages 32-34.

### SUMMARY OF THE INVENTION

It is hence an object of the invention to solve problems of the prior art and present a small-sized microwave oscillator excellent in phase noise characteristics and a low-noise converter for receiving satellite signal using the same.

To achieve the object, the microwave oscillator of the invention is characterized by the configuration in which MSL A released at one end is connected to the base terminal of a transistor, MSL B is connected to the collector terminal, a DR is disposed closely to the MSL A and MSL B to couple them electromagnetically, and a stabilized oscillation output is obtained by inducing parallel feedback from the collector to the base, and further the center of the DR is set closest to the position at which the distance from the released end on the MSL A is λg1/4, and HIL is merely connected to this position as a bias supply line to the base terminal, and therefore without using choke circuits which occupied a relatively wide area on the conventional circuit board, a small and stable microwave oscillator having excellent phase noise characteristics may be realized. Herein, λg1 is the guide wavelength in the MSL A.

In other configuration, the MSL B connected to the collector terminal of the transistor is also released at one end, and the center of the DR is set closest to the position at which the distance from the released end on the MSL B is λg2/4, and merely the HIL is connected as a bias supply line to the collector terminal, and therefore without using choke circuits conventionally added to the bias supply lines to both base and collector terminals, the size may be further reduced. Herein, λg2 is the guide wavelength in the MSL B.

Further, using the FET instead of the transistor, MSL A with a released end is connected to its gate terminal, and MSL B is connected to the drain terminal, and a DR is disposed closely to the MSL A and B to couple them electromagnetically, and a stabilized oscillation output is obtained by inducing a parallel feedback from the drain to the gate, and the center of the DR is set closest to the position at which the distance from the released end on the MSL A is λg1/4, and HIL is merely connected as a bias supply line to the gate terminal, and therefore without using choke circuits which occupied a relatively wide area on the conventional circuit board, a small and stable microwave oscillator having excellent phase noise characteristics may be realized.

In a different configuration, the MSL B connected to the drain terminal of the FET is also released at one end, and the center of the DR is set closest to the position at which the distance from the released end on the MSL B is λg2/4, and merely the HIL is connected as a bias supply line to the drain terminal, and therefore without using choke circuits conventionally added to the bias supply lines to both gate and drain terminals, the size may be further reduced.

By using any one of such microwave oscillators in the local oscillator for the low-noise converter for receiving satellite signal composed of a probe for converting the satellite signal in the circular waveguide obtained from a satellite signal receiving antenna into MSL mode, a low-noise amplifier, a mixer, a local oscillator, and an IF amplifier, a small and stable low-noise converter for receiving satellite signal having excellent phase noise characteristics may be realized.

Thus, by connecting the MSL released at one end to the base and/or collector terminal of the transistor or to the gate and/or drain terminal of the FET, setting the center of the DR closest to the position at which the distance from the released end on the MSL is λg/4, and merely connecting the HIL as a bias supply line to each terminal of the transistor or FET, conventional choke circuits are omitted, and a small and stable microwave oscillator having excellent phase noise characteristics and a low-noise converter for receiving satellite signal by using it are presented.

### BRIEF DESCRIPTION OF THE DRAWINGS

Fig. 1 is a circuit diagram of a microwave oscillator in embodiment 1 and embodiment 2 of the invention.
Fig. 2 is a circuit diagram of a microwave oscillator in embodiment 3 and embodiment 4 of the invention.
Fig. 3 is a block diagram of a microwave oscillator in embodiment 5 of the invention.
Fig. 4 is a block diagram of a microwave oscillator in embodiment 6 of the invention.
Fig. 5 is a diagram showing phase noise characteristics of the microwave oscillator in embodiment 6 of the invention.
Fig. 6 is a circuit diagram of a microwave oscillator in a prior art.

### DESCRIPTION OF THE PREFERRED EMBODIMENTS

Referring now to the drawings, preferred embodiments of the invention are described below.

### (Embodiment 1)

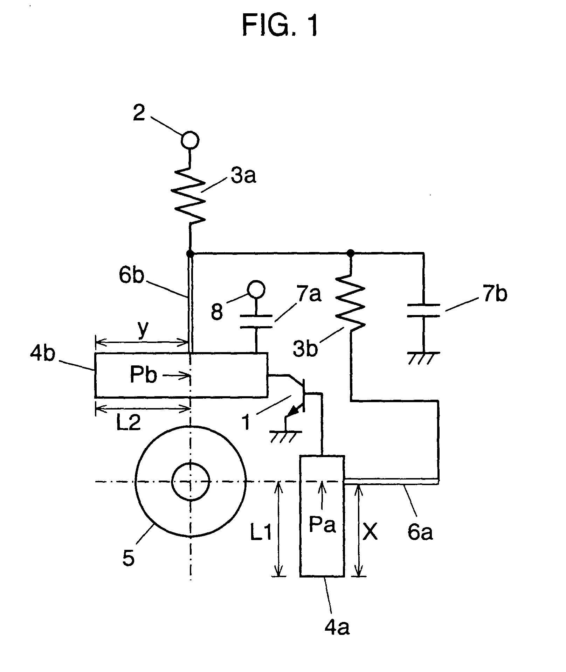

A circuit diagram of a microwave oscillator in embodiment 1 of the invention is shown in Fig. 1.

At a base terminal of a transistor 1, MSL 4a with a released end is connected, and HIL 6a and dc resistance 3b are connected serially to the side of line 4a as shown in Fig. 1, one end of the resistance 3b is connected to a bias voltage supply terminal 2 through dc resistance 3a, and a bias voltage is applied to the base terminal therefrom. At a collector terminal of the transistor 1, same as in the case of the base terminal, MSL 4b with a released end is connected, and HIL 6b and dc resistance 3a are connected serially to the side of line 4b as shown in Fig. 1, and led to the bias voltage supply terminal 2, and a bias voltage is applied to the collector terminal therefrom. The emitter terminal is directly grounded. On the other hand, in order to stabilize the oscillation, a DR 5 is disposed so that the position at which the distance from the released end on the MSL 4a and MSL 4b lines is L1 and L2 may be closest to the center of the DR 5. Setting L1 and L2 respectively at λg1/4 and λg2/4 (λg1 and λg2 are guide wavelengths of MSL 4a and MSL 4b respectively at the resonance frequency of DR 5), the MSL 4b connected to the collector and the MSL 4a connected to the base terminal are electromagnetically coupled through the DR 5, and a parallel feedback is induced between the collector and base of the transistor, and hence a microwave oscillation is stabilized at a desired frequency by the DR 5. This oscillation power is obtained from an output terminal 8 through a dc blocking capacitor 7a.

Supposing the position on the line 4a closest to the center of the DR 5 from the released end of the MSL 4a to be Pa, and the distance from the released end of the line 4a to the HIL 6a to be x, the distance from the released end to Pa is λg1/4 (L1 = λg1/4), and hence the line 4a is in short-circuited state at Pa, and as seeing the released end of the line 4a from Pa, the impedance Z(Pa) is a sufficiently small value. Therefore, when the HIL 6a is connected at this position of Pa, that is, when set at x = L1, the impedance of seeing the HIL 6a from the position of Pa is a sufficiently large value as compared with Z(Pa) without using choke circuit with a stab 4d in the prior art shown in Fig. 6, and it is possible to suppress sufficiently leak of the microwave electromagnetic field of the MSL 4a to the HIL 6a. Therefore, a small and stable microwave oscillator having excellent phase noise characteristics may be realized.

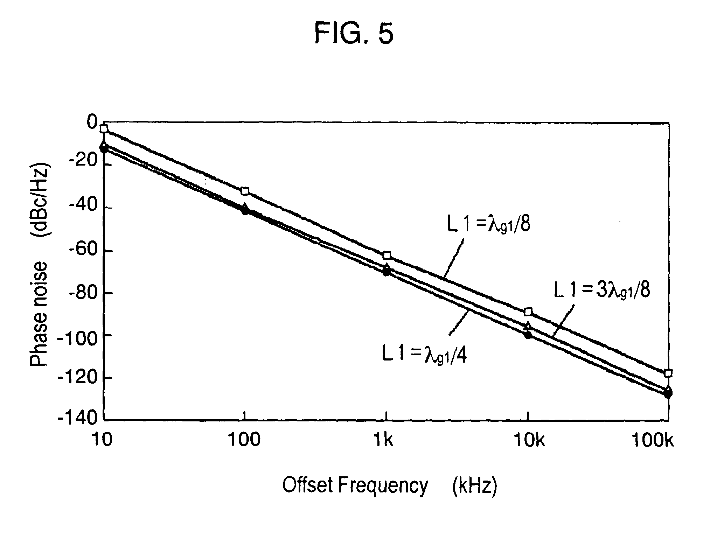

Fig. 5 shows phase noise characteristics of microwave oscillation output at λg1/8, λg1/4, and 3λg1/8. It is known from this diagram that the most favorable phase noise characteristics will be obtained at L1 = λg1/4.

In this embodiment, a voltage feedback system is used in the bias method of the transistor 1, but similar effects are obtained by other bias method such as current feedback system. Of course, same effects are obtained by using interdigital filter by MSL or the like in the dc blocking capacitor 7a.

### (Embodiment 2)

A circuit diagram of a microwave oscillator of this embodiment is same as that of embodiment 1 shown in Fig. 1. In this embodiment, supposing the distance from the released end of MSL 4b connected to a collector terminal of the transistor to the HIL 6b to be y, and the position on the line 4b closest to the center of the DR 5 from the released end of the MSL 4b to be Pb, the distance from the released end to Pb is λg2/4 (L2 = λg2/4), and hence the line 4b is in short-circuited state at Pb, as seeing the released end of the line 4b from Pb, the impedance Z(Pb) is a sufficiently small value. Therefore, when the HIL 6b is connected at this position of Pb, that is, when set at y = L2, the impedance of seeing the HIL 6b from the position of Pb is, same as in embodiment 1, a sufficiently large value as compared with Z(Pb) without using choke circuit with a stab 4f in the prior art shown in Fig. 5, and it is possible to suppress sufficiently leak of the microwave electromagnetic field of the MSL 4b to the HIL 6b. Therefore, a small and stable microwave oscillator having excellent phase noise characteristics may be realized.

In this embodiment, too, the bias method of the transistor 1 and dc blocking capacitor 7a may be varied same as in embodiment 1.

### (Embodiment 3)

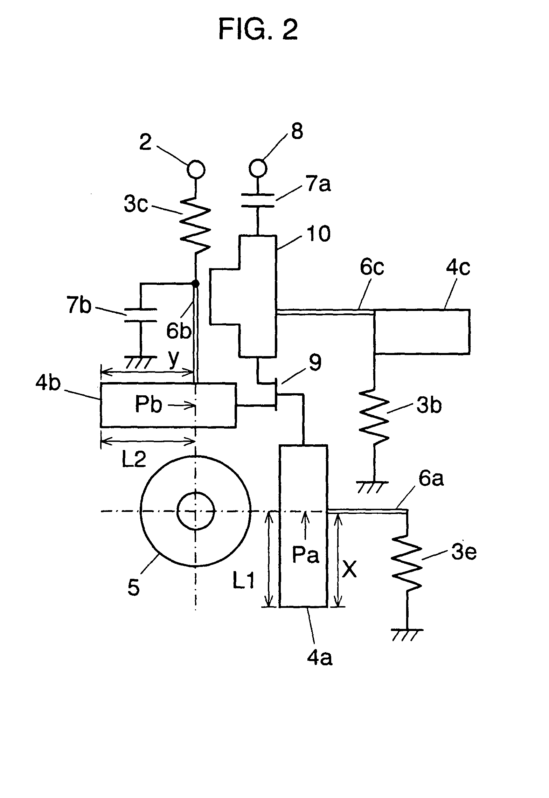

A circuit diagram of a microwave oscillator in embodiment 3 of the invention is shown in Fig. 2. At a gate terminal of FET 9, MSL 4a with a released end is connected, and HIL 6a and dc resistance 3e are connected serially to the side of line 4a as shown in Fig. 2, and one end of the resistance 3e is grounded. At a drain terminal of the FET 9, same as in the case of the gate terminal, MSL 4b with a released end is connected. At a side of the line 4b, as shown in Fig. 2, one end of HIL 6b is connected, and a dc resistance 3c and capacitor 7b are connected to other end, and the resistance 3c is led into a bias voltage supply terminal 2, from which a bias voltage is applied to the FET 9. The capacitor 7b is provided for grounding the microwave component leaking out from the HIL 6b. At a source terminal, one end of a impedance matching circuit 10 is connected, and other end is connected to an output terminal 8 through a dc blocking capacitor 7a. At the side of the circuit 10, as shown in Fig. 2, a choke circuit composed of HIL 6c and stab 4c and a dc resistance 3d are connected serially, and one end of the resistance 3d is grounded. On the other hand, to stabilize the oscillation, a DR 5 is disposed so that the position at which the distance from the released end on the MSL 4a and MSL 4b lines is L1 and L2 may be closest to the center of the DR 5. Setting L1 and L2 respectively at λg1/4 and λg2/4 (λg1 and λg2 are guide wavelengths of MSL 4a and MSL 4b respectively at the resonance frequency of DR 5), the MSL 4b connected to the drain terminal and the MSL 4a connected to the gate terminal are electromagnetically coupled through the DR 5, and a parallel feedback is induced between the drain and gate of the FET, and hence a microwave oscillation is stabilized at a desired frequency by the DR 5. This oscillation power is obtained from an output terminal 8 through an impedance matching circuit 10 and a dc blocking capacitor 7a.

Supposing the position on the line 4a closest to the center of the DR 5 from the released end of the MSL 4a to be Pa, and the distance from the released end of the line 4a to the HIL 6a to be x, the distance from the released end to Pa is λg1/4 (L1 = λg1/4), and hence the line 4a is in short-circuited state at Pa, and as seeing the released end of the line 4a from Pa, the impedance Z(Pa) is a sufficiently small value. Therefore, when the HIL 6a is connected at this position of Pa, that is, when set at x = L1, the impedance of seeing the HIL 6a from the position of Pa is a sufficiently large value as compared with Z(Pa) without using choke circuit with a stab 4d in the prior art shown in Fig. 5, and it is possible to suppress sufficiently leak of the microwave electromagnetic field of the MSL 4a to the HIL 6a. Therefore, a small and stable microwave oscillator having excellent phase noise characteristics may be realized.

Of course, same effects are obtained by using interdigital filter by MSL or the like in the dc blocking capacitor 7a.

### (Embodiment 4)

A circuit diagram of a microwave oscillator of this embodiment is same as that of embodiment 3 shown in Fig. 2. In this embodiment, supposing the distance from the released end of MSL 4b connected to a drain terminal of the FET 9 to the HIL 6b to be y, and the position on the line 4b closest to the center of the DR 5 from the released end of the MSL 4b to be Pb, the distance from the released end to Pb is λg2/4 (L2 = λg2/4), and hence the line 4b is in short-circuited state at Pb, as seeing the released end of the line 4b from Pb, the impedance Z(Pb) is a sufficiently small value. Therefore, when the HIL 6b is connected at this position of Pb, that is, when set at y = L2, the impedance of seeing the HIL 6b from the position of Pb is, same as in embodiment 3, a sufficiently large value as compared with Z(Pb) without using choke circuit with a stab 4f in the prior art shown in Fig. 6, and it is possible to suppress sufficiently leak of the microwave electromagnetic field of the MSL 4b to the HIL 6b. Therefore, a small and stable microwave oscillator having excellent phase noise characteristics may be realized.

In this embodiment, too, the dc blocking capacitor 7a may be varied same as in embodiment 3.

### (Embodiment 5)

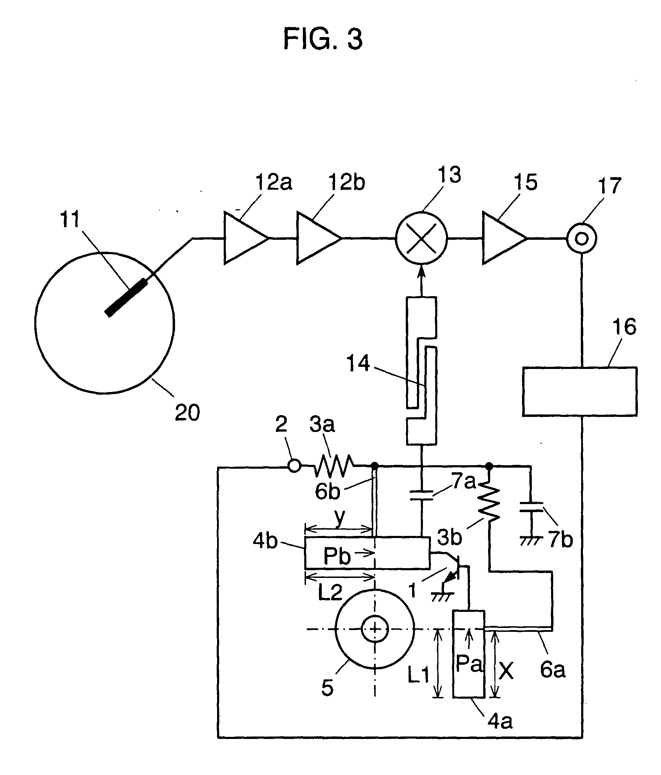

A block diagram of a low-noise converter for receiving satellite signal in embodiment 5 of the invention is shown in Fig. 3.

A satellite signal received by a receiving antenna is led into a circular waveguide 20, converted into MSL mode by a probe 11 provided in the guide, and amplified by a low-noise amplifier, and sent into a mixer 13 to be converted down to an intermediate frequency. As a local oscillator for feeding a local oscillation signal into the mixer 13, the microwave oscillator in embodiment 1 is used. That is, by connecting the HIL 6a for bias voltage supply to be applied to the base terminal of the transistor 1 from the released end of the MSL 4a to the position Pa of λg1/4 (x = λg1/4), this microwave oscillator does not require a choke circuit. In Fig. 3, the output signal of the microwave oscillator of embodiment 1 is supplied from the dc blocking capacitor 7a into the mixer 13 through a band-pass filter 14 formed of MSL, and the bias supply terminal 2 of the transistor 1 is connected to a stabilized dc power supply circuit 16. In the mixer 13, the satellite signal and local oscillation signal are mixed, and the IF component is taken out from the output port of the mixer 13, amplified in an IF amplifier 15, and led to an IF output terminal 17 and delivered outside. On the other hand, the dc voltage to be supplied to the stabilized dc power supply circuit is superposed on the IF output signal from outside, and is applied from the output terminal 17.

Thus, in this embodiment, since the microwave oscillator in embodiment 1 is used in the low-noise converter for receiving satellite signal as the local oscillator, a small and stable low-noise converter for receiving satellite signal having excellent phase noise characteristics is realized.

Fig. 5 shows phase noise characteristics of microwave oscillation output at λg1/8, λg1/4, and 3λg1/8. It is known from this diagram that the most favorable phase noise characteristics will be obtained at L1 = λg1/4.

### (Embodiment 6)

A block diagram of a low-noise converter of this embodiment is same as that of embodiment 5 shown in Fig. 3.

In this embodiment, the microwave oscillator in embodiment 2 is used as the local oscillator for generating local oscillation signal. That is, by connecting the HIL 6b for bias voltage supply to be applied to the collector terminal of the transistor 1 from the released end of the MSL 4b to the position Pb of λg2/4 (y = λg2/4), this microwave oscillator does not require a choke circuit. Thus, in this embodiment, since the microwave oscillator in embodiment 2 is used in the low-noise converter for receiving satellite signal as the local oscillator, a small and stable low-noise converter for receiving satellite signal having excellent phase noise characteristics is realized.

### (Embodiment 7)

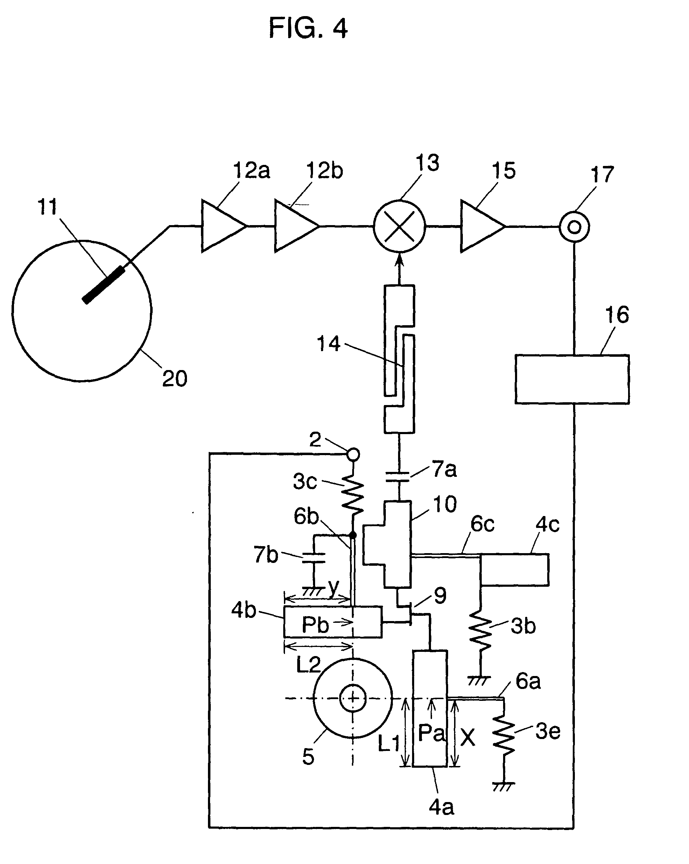

A block diagram of a low-noise converter for receiving satellite signal in embodiment 7 of the invention is shown in Fig. 4.

A satellite signal received by a receiving antenna is led into a circular waveguide 20, converted into MSL mode by a probe 11 provided in the guide, and amplified by a low-noise amplifier, and sent into a mixer 13 to be converted down to an intermediate frequency. As a local oscillator for feeding a local oscillation signal into the mixer 13, the microwave oscillator in embodiment 3 is used. That is, by connecting the HIL 6a for bias voltage supply to be applied to the gate terminal of the FET 9 from the released end of the MSL 4a to the position Pa of λ/4 (x = λg1/4), this microwave oscillator does not require a choke circuit. In Fig. 4, the output signal of the microwave oscillator of embodiment 3 is supplied from the dc blocking capacitor 7a into the mixer 13 through a band-pass filter 14 formed of MSL, and the bias supply terminal 2 of the FET 9 is connected to a stabilized dc power supply circuit 16. In the mixer 13, the satellite signal and local oscillation signal are mixed, and the IF component is taken out from the output port of the mixer 13, amplified in an IF amplifier 15, and led to an IF output terminal 17 and delivered outside. On the other hand, the dc voltage to be supplied to the stabilized dc power supply circuit is superposed on the IF output signal from outside, and is applied from the output terminal 17.

Thus, in this embodiment, since the microwave oscillator in embodiment 3 is used in the low-noise converter for receiving satellite signal as the local oscillator, a small and stable low-noise converter for receiving satellite signal having excellent phase noise characteristics is realized.

### (Embodiment 8)

A block diagram of a low-noise converter of this embodiment is same as that of embodiment 7 shown in Fig. 4.

In this embodiment, the microwave oscillator in embodiment 4 is used as the local oscillator for generating local oscillation signal. That is, by connecting the HIL 6b for bias voltage supply to be applied to the drain terminal of the FET 9 from the released end of the MSL 4b to the position Pb of λg2/4 (y = λg2/4), this microwave oscillator does not require a choke circuit. Thus, in this embodiment, since the microwave oscillator in embodiment 4 is used in the low-noise converter for receiving satellite signal as the local oscillator, a small and stable low-noise converter for receiving satellite signal having excellent phase noise characteristics is realized.

Thus, by connecting the MSL released at one end to the base and/or collector terminal of the transistor or to the gate and/or drain terminal of the FET, setting the center of the DR closest to the position at which the distance from the released end on the MSL is λg/4, and merely connecting the HIL as a bias supply line to each terminal of the transistor or FET, conventional choke circuits are omitted, and a small and stable microwave oscillator having excellent phase noise characteristics and a low-noise converter for receiving satellite signal by using it are presented.

## Claims

1. A microwave oscillator for inducing parallel feedback from a second port to a first port of a transistor (1) comprising:
a dielectric resonator (5) for stabilizing an oscillation frequency of said microwave oscillator,
a first microstrip line (4a) having a length greater than a first quarter guide-wavelength (λg1/4) thereof, one end of said first microstrip line (4a) being directly coupled to the first port of said transistor (1) and the other end of said first microstrip line (4a) being open-circuited, and a point (Pa) on said first microstrip line (4a) that is closest to the centre of said dielectric resonator (5) is located at a distance (L1) from said open-circuited other end corresponding to the first quarter guide-wavelength (λg1/4);
a second microstrip line (4b) having a length greater than a second quarter guide-wavelength (λg2/4) thereof, one end of said second microstrip line (4b) being directly coupled to the second port of said transistor (1) and the other end of said first microstrip line (4a) being open-circuited, and a point (Pb)on said second microstrip line (4b) that is closest to the centre of said dielectric resonator (5) is located at a distance (L2) from said open-circuited other end corresponding to the second quarter guide-wavelength (λg2/4);
at least one high impedance line (6a, 6b) for supplying respective biases to said first and second ports of said transistor (1), **characterised in that**
said at least one high impedance line (6a, 6b) is not associated with respective choke stubs and each high impedance line (6a, 6b) is connected to said point (Pa, Pb) on a respective first microstrip line (4a, 4b).

2. The microwave oscillator as defined in claim 1, wherein said transistor (1) is a bipolar transistor and the first and second ports of said transistor are the base and collector, respectively.

3. The microwave oscillator as defined in claim 1, wherein said transistor (1) is a field effect transistor and the first and second ports of said transistor are the gate and drain, respectively.

4. A low-noise converter incorporated in a microwave receiving antenna comprising:
(a) a waveguide for transmitting a satellite signal received in said receiving antenna,
(b) a waveguide probe for converting the satellite signal in said waveguide into a microstrip line mode,
(c) a low-noise amplifier of which input port is coupled to said waveguide probe,
(d) a mixer for receiving an output signal of said low-noise amplifier, and
(e) a local oscillator of which output port is coupled to said mixer,
wherein said local oscillator includes the microwave oscillator of anyone of claims 1 to 3.

## Revendications

1. Oscillateur hyperfréquence destiné à induire une contre-réaction parallèle depuis une seconde borne vers une première borne d'un transistor (1) comprenant :
un résonateur diélectrique (5) destiné à stabiliser une fréquence d'oscillation dudit oscillateur hyperfréquence,
une première ligne microruban (4a) présentant une longueur supérieure à un premier quart de longueur d'onde de guide (λg1/4) de celle-ci, une extrémité de ladite première ligne microruban (4a) étant directement reliée à la première borne dudit transistor (1) et l'autre extrémité de ladite première ligne microruban (4a) étant en circuit ouvert, et un point (Pa) sur ladite première ligne microruban (4a) qui est le plus proche du centre dudit résonateur diélectrique (5) est situé à une distance (L1) de ladite autre extrémité en circuit ouvert correspondant au premier quart de longueur d'onde de guide (λg1/4),
une seconde ligne microruban (4b) présentant une longueur supérieure à un second quart de longueur d'onde de guide (λg2/4) de celle-ci, une extrémité de ladite seconde ligne microruban (4b) étant directement reliée à la seconde borne dudit transistor (1) et l'autre extrémité de ladite première ligne microruban (4a) étant en circuit ouvert, et un point (Pb) sur ladite seconde ligne microruban (4b) qui est le plus proche du centre dudit résonateur diélectrique (5) est situé à une distance (L2) de ladite autre extrémité en circuit ouvert correspondant au second quart de longueur d'onde de guide (λg2/4),
au moins une ligne à haute impédance (6a, 6b) destinée à fournir des polarisations respectives auxdites première et seconde bornes dudit transistor (1), **caractérisé en ce que**
ladite au moins une ligne à haute impédance (6a, 6b) n'est pas associée à des adaptateurs d'impédance d'arrêt respectifs et chaque ligne à haute impédance (6a, 6b) est reliée audit point (Pa, Pb) sur une première ligne microruban respective (4a, 4b).

2. Oscillateur hyperfréquence selon la revendication 1, dans lequel ledit transistor (1) est un transistor bipolaire et les première et seconde bornes dudit transistor sont respectivement la base et le collecteur.

3. Oscillateur hyperfréquence selon la revendication 1, dans lequel ledit transistor (1) est un transistor à effet de champ et les première et seconde bornes dudit transistor sont respectivement la grille et le drain.

4. Convertisseur à faible bruit incorporé dans une antenne de réception hyperfréquence comprenant :
(a) un guide d'onde destiné à transmettre un signal satellite reçu dans ladite antenne de réception,
(b) une sonde de guide d'onde destinée à convertir le signal satellite dans ledit guide d'onde en mode de ligne microruban,
(c) un amplificateur à faible bruit dont la borne d'entrée est reliée à ladite sonde de guide d'onde,
(d) un mélangeur destiné à recevoir un signal de sortie dudit amplificateur à faible bruit, et
(e) un oscillateur local dont la borne de sortie est reliée audit mélangeur,
où ledit oscillateur local comprend l'oscillateur hyperfréquence de l'une quelconque des revendications 1 à 3.

## Patentansprüche

1. Mikrowellenoszillator zum Hervorrufen eines parallelen Feedbacks aus einem zweiten Anschluss zu einem ersten Anschluss eines Transistors (1), der umfasst:
einen dielektrischen Resonator (5) zum Stabilisieren einer Schwingungsfrequenz des Mikrowellenoszillators,
eine erste Mikrostreifenleitung (4a) mit einer Länge, die größer als eine erste viertel Leiterwellenlänge (λg1/4) davon ist, wobei ein Ende der ersten Mikrostreifenleitung (4a) direkt an den ersten Anschluss des Transistors (1) gekoppelt ist und das andere Ende der ersten Mikrostreifenleitung (4a) offen ist, und ein Punkt (Pa) auf der ersten Mikrostreifenleitung (4a), der zum Mittelpunkt des dielektrischen Resonators (5) am nächsten ist, sich in einem Abstand (L1) von dem offenen anderen Ende befindet, welcher der ersten viertel Leiterwellenlänge (λg1/4) entspricht;
eine zweite Mikrostreifenleitung (4b) mit einer Länge, die größer als eine zweite viertel Leiterwellenlänge (λg2/4) davon ist, wobei ein Ende der zweiten Mikrostreifenleitung (4b) direkt an den zweiten Anschluss des Transistors (1) gekoppelt ist und das andere Ende der ersten Mikrostreifenleitung (4a) offen ist, und ein Punkt (Pb) auf der zweiten Mikrostreifenleitung (4b), der zum Mittelpunkt des dielektrischen Resonators (5) am nächsten ist, sich in einem Abstand (L2) von dem offenen anderen Ende befindet, welcher der zweiten viertel Leiterwellenlänge (λg2/4) entspricht;
mindestens eine hochohmige Leitung (6a, 6b) zum Speisen der entsprechenden Vorspannungen zu dem ersten und dem zweiten Anschluss des Transistors (1), **dadurch gekennzeichnet, dass**
die mindestens eine hochohmige Leitung (6a, 6b) nicht mit entsprechenden Drosselstichleitungen assoziiert ist und jede hochohmige Leitung (6a, 6b) mit dem Punkt (Pa, Pb) auf einer entsprechenden ersten Mikrostreifenleitung (4a, 4b) verbunden ist.

2. Mikrowellenoszillator nach Anspruch 1, **dadurch gekennzeichnet, dass** der Transistor (1) ein Bipolartransistor ist, und der erste und der zweite Anschluss des Transistors die Basis beziehungsweise der Kollektor ist.

3. Mikrowellenoszillator nach Anspruch 1, **dadurch gekennzeichnet, dass** der Transistor (1) ein Feldeffekttransistor ist, und der erste und der zweite Anschluss des Transistors das Gate beziehungsweise der Drain ist.

4. Rauscharmer Umwandler, der Bestandteil einer Mikrowellenempfangsantenne ist und umfasst:
(a) einen Wellenleiter zum Übertragen eines Satellitensignals, das in der Empfangsantenne empfangen wird,
(b) eine Wellenleitersonde zum Umwandeln des Satellitensignals in dem Wellenleiter in einen Mikrostreifenleitungsmodus,
(c) einen rauscharmen Verstärker, dessen Eingangsanschluss an die Wellenleitersonde gekoppelt ist,
(d) einen Mischer zum Empfangen eines Ausgangssignals des rauscharmen Verstärkers, und
(e) einen lokalen Oszillator, dessen Ausgangsanschluss an den Mischer gekoppelt ist,
**dadurch gekennzeichnet, dass** der lokale Oszillator den Mikrowellenoszillator nach einem der Ansprüche 1 bis 3 aufweist.
